(19) Europäisches Patentamt
European Patent Office
Office européen des brevets

(11) **EP 3 382 418 A1**

(12) **EUROPEAN PATENT APPLICATION**

(43) Date of publication:
**03.10.2018 Bulletin 2018/40**

(51) Int Cl.:
***G01R 35/00*** (2006.01)  ***G01R 29/08*** (2006.01)

(21) Application number: **18156850.2**

(22) Date of filing: **15.02.2018**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD TN**

(30) Priority: **15.02.2017 CN 201710081830**

(71) Applicant: **Beihang University**
**100083 Beijing (CN)**

(72) Inventors:
• **DAI, Fei**
  **Beijing, 100083 (CN)**
• **JIN, Yuntao**
  **Beijing, 100083 (CN)**
• **GAO, Zhanwei**
  **Beijing, 100083 (CN)**

(74) Representative: **Gong, Jinping**
**Ortnitstraße 9**
**81925 München (DE)**

(54) **A SPATIAL RESOLUTION CALIBRATION METHOD BASED ON USING PLANAR TRANSMISSION LINES**

(57) The invention derives a more effective way of description from the traditional definition on the probe spatial resolution, and put forward a spatial resolution calibration method based on the controllable probe with axial-distribution EMF above the planar transmission lines, including to give derivative definition on the probe spatial resolution through normalization, to set up controllable probe calibration platform with axial distribution of EMF above the planar transmission line; suitable for spatial resolution calibration with travelling wave in case of high frequency and standing wave in case of low frequency, which can effectively control and reduce the errors generated by the probe size as well as sensitivity, high frequency and low frequency of signal detection equipment.

Fig.1a

**Description**

The priority date of the Chinese priority application is Feb 15, 2017 and the application number is 201710081830.5. The title of the invention is *A spatial resolution calibration method based on the controllable probe with axial-distribution EMF of planar transmission lines.* All the contents of the priority application have been incorporated into the present Application by reference in its entirety.

**Technical field**

The invention discloses a spatial resolution calibration method for probe in magnetic field and electric field, which involves setting up a kind of controllable structure featuring axial-distribution for space of electromagnetic field right above the planar transmission line. It falls into electromagnetic and antenna metering fields.

**Background technologies**

During the process of screening and rectifying of EMI (Electromagnetic Interference), field probe is often used to disturb and position the interference source. The probe's spatial resolution is an important factor influencing the positioning accuracy of interference source.

The spatial resolution of field probe is supposed to be able to differentiate the minimum spatial displacement distance for changes of electromagnetic field distribution. The current calibration method is that after the signal is input at the origin end of micro-strip line, parallelly and transversely move (i.e. vertical to the transmission direction) the probe at a certain height right above the conduction band. With the field strength distribution measured transversely by the probe and spectrometer, the spatial resolution of the probe is defined by the space between two -6 dB drop points. However, this method has multiple error factors, including (1) The measurement doesn't eliminate the influence of probe sizes. Therefore, even if the measurement value of the spatial resolution is less than that of probe, it won't be recognized. An effective value must be no less than that of the probe. (2) The spectrometer and other signal detection equipment must have sufficient sensitivity and amplitude resolution.

Otherwise, they can't effectively differentiate the 6dB difference of weak signal. (3) In case of high frequency, there will be violent changes in transverse field. Any minimum displacement distance of probe may bring about relatively big changes of measurement range. And it's hard to accurately determine the amplitude space of 6dB difference. (4) In case of low frequency, there will be slow changes in transverse field. Only relatively big displacement distance of probe may bring about 6dB of measurement range. The measurement value may be far less than the real spatial resolution.

**Invention contents**

The invention derives a much more effective description approach from the traditional definition of the probe's spatial resolution, and put forward a spatial resolution calibration method based on the controllable probe with axial-distribution EMF right above the planar transmission lines, including those suitable for high-frequency travelling wave calibration method and for low-frequency standing wave calibration method, which can effectively control and reduce the four errors mentioned above.

The invention mainly include the following contents:

**Content One: the definition of the spatial resolution for the probe**

The existing spatial resolution is defined as the minimum space range that the probe can differentiate the field strength with the changes of position. The spatial resolution is generally used as an absolute index. However, there are several prerequisites to determine the change of field strength. First, the whole measurement system must have sufficient amplitude sensitivity and amplitude dynamic range so as to make sure the strong and weak signals as well as their changes won't exceed the measurement range, and prevent the changes of strong or weak signals from being incorrectly shown in the measurement system. Second, the recognizable signal change for field strength is determined by the amplitude resolution of signal detection & analysis equipment. The probe is a sensor converting the EMF signal to voltage signal. Therefore, however the EMF amplitude changes, the passive probe will convert it into the corresponding voltage change. The question is whether the voltage change can be recognized is up to the amplitude resolution of signal detection & analysis equipment connected with the probe. Third, the recognizable change of field strength is constrained by the space gradient. Under the precondition of other equal requirements, a same probe will have a different spatial resolution in the spatial space of different gradient. The higher the absolute value of the field space, the more optimum spatial resolution the field probe will have.

On the basis of the theory mentioned above, under the precondition of making sure the whole system with the probe and signal measurement & analysis equipment included has sufficient amplitude sensitivity and dynamic range, the invention adopts the following method to redefine the spatial resolution of the probe:

1. To define the *spatial resolution* with spatial resolution @ amplitude accuracy coverage (confidence coefficient is xx%): Take PXIN9030A signal analyzer of Keysight as an example. The amplitude range of this signal analyzer is $\pm0$ .19dB within 10Hz $\sim$ 3 .6GHz and the confidence coefficient of the measurement result is 95%. Therefore, if the testing system of near-field EMI use this signal analyzer, according to the representation of the spatial resolution for near-field probe given above, the spatial resolution for a certain near-field probe can be expressed as 2mm@0 .38dB(confidence coefficient is 95%).

The coverage range of amplitude accuracy is the amplitude resolution of the signal detection & analysis equipment. Meanwhile, the spatial resolution in "spatial resolution @ coverage of amplitude accuracy (confidence coefficient is xx%)" refers to the spatial dimension of probe changes. The above-mentioned contents shall be determined by the knowledge mastered by the technical personnel in this field.

2.Furthermore, to define the spatial resolution with the space change range of probe @(field strength change=am-plitude resolution, $|\vec{A}|(x,y,z)(dB)$): in the above-mentioned representation, the spatial resolution of probe is further defined by three aspects, i.e. space range, field strength change (i.e. amplitude resolution) and field distribution function. Under such definition mode, the following steps can be taken to normalize the spatial resolution:

(1) The amplitude resolution of measurement & analysis equipment is used as the base for recognizable field strength change to measure the spatial resolution, i.e. the spatial resolution can be derivatively defined as space range of probe change @ (field strength change= amplitude resolution). We can see that the practical spatial resolution shall be the spatial resolution of the whole measurement system with the probe and signal measurement & analysis included. The amplitude resolution of the measurement system is often expressed in relative quantity, i.e. logarithm. The unit is dB. Therefore, it's an exception for derivative definition to adopt the probe displacement distance (in case the measurement amplitude changes by 6dB) as the traditional method of the spatial resolution.

(2) To describe the distribution of the spatial field $\vec{A}$ with logarithm. Here, $\vec{A}$ stands for electric field or magnetic field. The modulus value of $\vec{A}$ shall be $|\vec{A}|(x,y,z)(dB) = 20\log[|\vec{A}|(x,y,z)]$. Therefore, in this space, the spatial resolution can be further derivatively defined as the spatial range of probe change @ (field strength change= amplitude resolution, $|\vec{A}|(x,y,z)(dB)$).

**Content two: the controllable probe calibration platform with axis-distribution EMF right above the planar transmission line**

Step 1: Select the detailed form of multi-conductor planar transmission line used for setting up calibration scale (such as micro-strip line, coplanar waveguide etc.) to make open-circuit or short-circuit setup at the terminal of transmission line so as to make it run under pure standing wave.

Furthermore, the matching load is added to the terminal of transmission line so as to make it run under travelling wave.

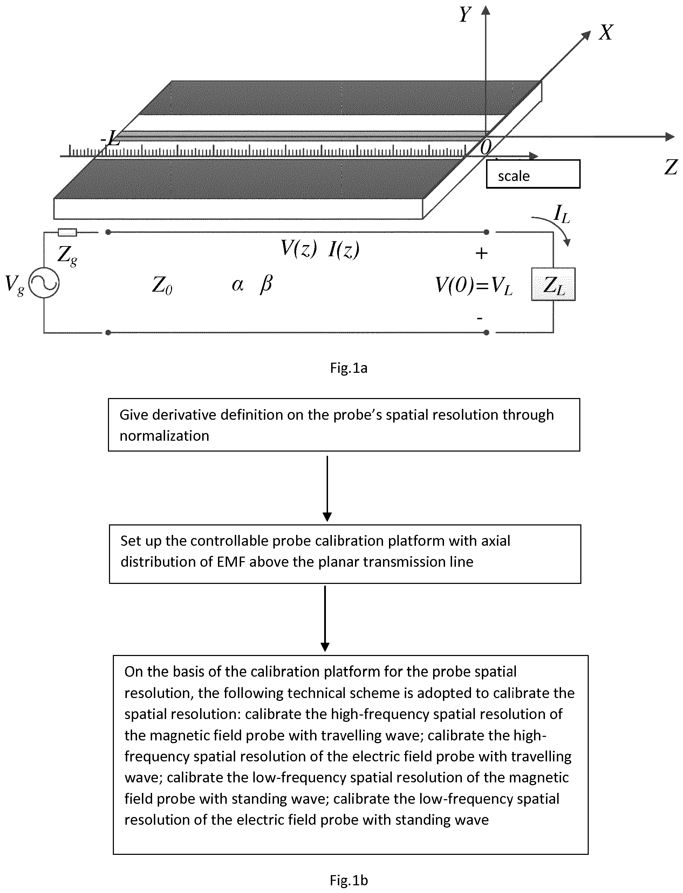

Details: Make non-closed and even planar transmission line with length L and characteristic impedance $Z_0$, such as micro-strip line, coplanar waveguide etc. Define the forward direction of signal transmission along transmission line as Z and the vertical direction as **X** within the plane of transmission line. Define the direction vertical to the plane of transmission line as Yand the origin of coordinates at the terminal of conduction band as indicated in Fig. 1a. Electromagnetic field exists in the air exposed above the transmission line.

Step 2: In combination with the above-mentioned micro-strip line, coplanar waveguide and other multi-conductor even transmission line, under standing wave or travelling wave, use the correlation of TEM (Transverse Electric and Magnetic Field) of voltage wave/ current wave on the transmission line and excited near the transmission line to set up calibration scale with solvable features and meanwhile corresponding to the EMF distribution used for calibrating the spatial resolution of near-field probe. Furthermore, the calibration scale is parallel to the conduction band along Z direction and has degree marks.

Step 3: Measure the attenuation factor $\alpha$ along Z direction of transmission line. Unit: 1/m. From the EMF theory and micro-wave technologies, we can see that the attenuation factor along Z direction of EMF right above the conduction band of transmission line shall be $\alpha$.

Therefore, the forward electric field can be expressed as $\overrightarrow{E^+}(z) = \overrightarrow{E_0^+}e^{-\alpha z}e^{-j\beta z}$.

The forward magnetic field can be expressed as $\overrightarrow{H^+}(z) = \overrightarrow{H_0^+}e^{-\alpha z}e^{-j\beta z}$.

β is phase-shift factor. β can be omitted when taking account of only modulus value of field quantity, i.e.

$$\left|\overrightarrow{E^+}\right|(z) = \left|\overrightarrow{E_0^+}\right| e^{-\alpha z}, \quad \left|\overrightarrow{H^+}\right|(z) = \left|\overrightarrow{H_0^+}\right| e^{-\alpha z}。$$

Similarly, the reverse electric field and reverse field modulus value excited by the reflection signal inside the transmission line are as follows respectively:

$$\left|\overrightarrow{E^-}\right|(z) = \left|\overrightarrow{E_0^-}\right| e^{\alpha z}, \quad \left|\overrightarrow{H^-}\right|(z) = \left|\overrightarrow{H_0^-}\right| e^{\alpha z}$$

Step 4: Input one signal at the origin end of transmission line and load $Z_L$ at the terminal end. The reflection coefficient at the terminal:

$$\Gamma(0) = \Gamma_L = |\Gamma_L| e^{j\varphi_L}$$

From the EMF theory and micro-wave technologies, we can see that the electric field above the conduction band is proportional to the voltage inside the transmission line and the magnetic field is proportional to the current inside the transmission line. At a common height, the axial distribution of electric field can be expressed as:

$$\vec{E}(z) = \overrightarrow{E^+}(z) + \overrightarrow{E^-}(z) = \overrightarrow{E_0^+} e^{-\alpha z} e^{-j\beta z} + \overrightarrow{E_0^-} e^{\alpha z} e^{j\beta z} = \overrightarrow{E_0^+} e^{-\alpha z} e^{-j\beta z}[1 + \Gamma(z)] =$$

$$\overrightarrow{E_0^+} e^{-\alpha z} e^{-j\beta z}\left[1 + |\Gamma_L| e^{j\varphi_L} e^{2\alpha z} e^{j2\beta z}\right],$$

$$\vec{H}(z) = \overrightarrow{H_0^+} e^{-\alpha z} e^{-j\beta z}\left[1 - |\Gamma_L| e^{j\varphi_L} e^{2\alpha z} e^{j2\beta z}\right]。$$

Futhermore,
$$\left|\vec{E}(z)\right| = \left|\overrightarrow{E_0^+}\right| e^{-\alpha z}\left|1 + |\Gamma_L| e^{2\alpha z} e^{j(\varphi_L + 2\beta z)}\right| =$$

$$\left|\overrightarrow{E_0^+}\right| e^{-\alpha z}\sqrt{1 + |\Gamma_L|^2 e^{4\alpha z} + 2|\Gamma_L| e^{2\alpha z}\cos(\varphi_L + 2\beta z)}, \left|\vec{H}(z)\right| = \left|\overrightarrow{H_0^+}\right| e^{-\alpha z}\left|1 - |\Gamma_L| e^{2\alpha z} e^{j(\varphi_L + 2\beta z)}\right| =$$

$$\left|\overrightarrow{H_0^+}\right| e^{-\alpha z}\sqrt{1 + |\Gamma_L|^2 e^{4\alpha z} - 2|\Gamma_L| e^{2\alpha z}\cos(\varphi_L + 2\beta z)}$$

Therefore, to change the load $Z_L$ of terminal can control the axial distribution of EMF above the planar transmission line.

Step 5: Add fixable probe and move electromechanical structure with probe moving along X, Y and Z axis. Together with planar transmission line and scale, they form calibration platform for spatial resolution of probe.

**Content three: calibration method of high-frequency travelling wave for field probe**

Step 1: Input one signal at the origin end of transmission line and connect matching load at the loading end. In this way, the travelling wave will occur inside the transmission line and has no reverse signal. The field right above the conduction band of transmission line: $|\vec{H}|(z) = \left|\overrightarrow{H^+}\right|(z) = \left|\overrightarrow{H_0^+}\right| e^{-\alpha z}.$

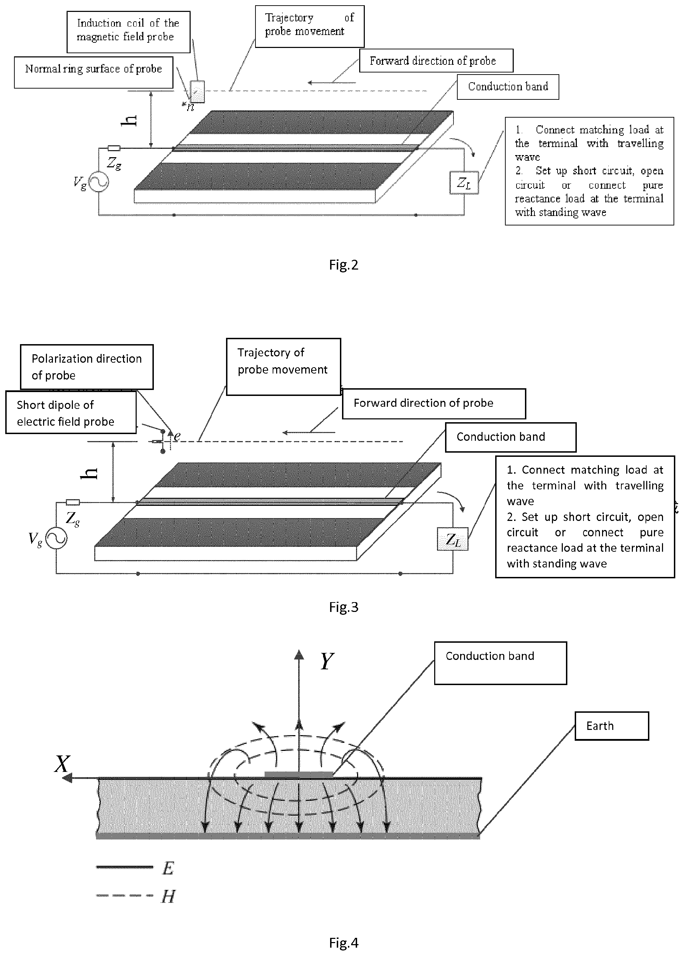

Step 2: Set up field probe at a certain height right above the conduction band of transmission line. The probe outputs signal to measure and analyze equipment as indicated in Fig.2. Adjust the orientation of signal source, measurement, analysis and reception equipment as well as the normal ring surface of probe until the signal can be clearly observed, and make sure that the measurement, analysis and reception equipment has sufficient amplitude dynamic range.

Step 3: Keep the height unchanged and make probe move in the direction of signal transmission of the line.

Please record the change of signal measured. The change of signal measured is equal to the displacement distance $\Delta l$ of the system amplitude resolution $R_A$ (dB) . This distance shall be the spatial resolution specified in the derivative definition. At this time, the field modulus value measured by the probe changes by $\Delta|\vec{H}|$ (dB) . Therefore, the spatial resolution can be expressed as $\Delta l@ (\Delta|\vec{H}| = R_A)$.

Step 4: Furthermore, the derivative definition of the spatial resolution in the calibration field is

$$\Delta l@ \left( \Delta|\vec{H}| = R_A, \left|\overrightarrow{H_0^+}\right| e^{-\alpha z} \right).$$

**Content four: calibration method of high-frequency travelling wave for field probe**

Step 1: Input one signal at the origin end of transmission line and connect matching load at the loading end. In this way, the travelling wave will occur inside the transmission line and has no reverse signal. The electric field right above the conduction band of transmission line:

$$\left|\vec{E}\right|(z) = \left|\overrightarrow{E^+}\right|(z) = \left|\overrightarrow{E_0^+}\right| e^{-\alpha z}.$$

Step 2: Set up the electric field probe at a certain height right above the conduction band of transmission line. The probe outputs signal to measure and analyze equipment as indicated in Fig.3. Adjust the orientation of signal source, measurement, analysis and reception equipment as well as the polarization of probe until the signal can be clearly observed, and make sure that the measurement and analysis equipment has sufficient amplitude dynamic range.

Step 3: Keep the height unchanged and make probe move in the direction of signal transmission of the line. Please record the change of signal measured. The change of signal measured is equal to the displacement distance $\Delta l$ of the system amplitude resolution $R_A$ (dB) . This distance shall be the spatial resolution specified in the derivative definition. At this time, the electric field modulus value measured by the probe changes by $\Delta|\vec{E}|$ (dB). Therefore, the spatial resolution can be expressed as $\Delta l@ (\Delta|\vec{E}| = R_A)$.

Step 4: furthermore, the derivative definition of the spatial resolution in the calibration field is

$$\Delta l@ \left( \Delta|\vec{H}| = R_A, \left|\overrightarrow{E_0^+}\right| e^{-\alpha z} \right).$$

**Content five: calibration method of low-frequency standing wave for field probe**

When setting up open circuit or short circuit of the terminal, the modulus value of electric current or voltage wave on the transmission line has the distribution of sine function along the longitudinal extension direction of transmission line. From the theories of transmission line and EM wave transmission wave, it's quite clear that the spatial distribution of electric voltage wave or electric current wave on the transmission line is relevant to the distribution of EM wave excited near the transmission line, i.e. when the transmission line run under pure standing wave, the modulus value or effective value of field quantity for EM wave excited near the transmission line is also distributed with the same sine function. In combination with the simulation of three-dimensional full-wave EMF as well as existing experience & formula, we can make further and more detailed description on the spatial distribution features on the measurement baseline of calibration scale with sine function. Meanwhile, during the process of simulated analysis, the spatial geometric parameters of calibration scale can be dynamically adjusted to acquire the expected field quantity distribution. In combination with the resolvable features of field quantity distribution, after the expected field quantity distribution is obtained, record the spatial geometric parameters of calibration scale, which are used as design input parameters for calibrating the processing of scale.

On this basis, the invention puts forward two technological approaches of linear fitting and analysis in order to calibrate the spatial resolution.

Step 1: In combination with the multi-conductor even transmission line, under standing wave, use the correlation of TEM (Transverse Electric and Magnetic Field) of voltage wave/ current wave on the transmission line and excited near the transmission line to set up calibration scale with solvable features and meanwhile corresponding to the EMF distribution used for calibrating the spatial resolution of near-field probe. The above-mentioned Content 2 can be referred for this step.

Step 2: on the basis of calibration scale set up in Step 1, when the calibration scale run under pure standing wave, in combination with the simulation of three-dimensional full-wave EMF as well as existing experience & formula, designate the areal distribution of linear fitting on the calibration scale. Details are:

In view that the modulus value or effective value of field quantity for EMF wave on the baseline has the spatial distribution features of sine functions, make linear fitting on the function ($y$ = sin($x$), $x \in \left(\dfrac{\pi}{2}, \pi\right)$) with multiple zones and high accuracy (accuracy error is no higher than 1%). In combination with the practical measurement needs, on the basis of simulation results of three-dimensional full-wave EMF as well as the analysis and calculation of existing experience and formula, through anti-normalization, designate the practical measurement zone corresponding to the calibration scale on the calibration scale before anti-normalization.

Step 3: choose a regional length larger than the pre-estimated value of spatial resolution for probe to be calibrated from the practical linear fitting zone designated on the calibration scale and a sub-zone, which has no zero rate of change for the modulus value or effective value of field quantity on the measurement baseline, as the calibration zone of spatial resolution for near-field probe. Furthermore, finish the calibration on the spatial resolution of near-field probe within the calibration zone. Details are as follows:

(1) Through anti-normalization specified in Step 2, choose a regional length larger than the pre-estimated value of spatial resolution for probe to be calibrated from the practical linear fitting zone designated on the calibration scale and a sub-zone, which has no zero rate of change for the modulus value or effective value of field quantity on the measurement baseline, as the calibration zone of spatial resolution for near-field probe.

(2) Move the near-field probe with constant speed on the measurement baseline within the calibration zone. The measurement baseline is located on the magnetic or electric wall plane of TEM wave field, which is formed by the calibration scale. The extension direction of measurement baseline is consistent with the longitudinal extension direction of the calibration scale so as to enhance the coupling of fields and increase measurement accuracy. When moving the probe, mark the reading changes of receptor or spectrometer in the corresponding measurement system. The probe displacement distance corresponding to the minimum reading change shall be the spatial resolution of the near-field probe. The near-field probe is divided into electric field probe and magnetic field probe. The magnetic field is much more sensitive to the spatial position change. Magnetic field probe is more used for the near-field EMI testing system. Hereinafter, the magnetic field probe will be used as typical cases in order to make detailed description on the calibration measurement process.

(3) In order to reduce the error generated during the calibration of near-field probe spatial resolution and by modulus value or effective value of field quantity under different rate of spatial change, the correction coefficient m is introduced into the calibration result. Multiply the correction coefficient and the probe spatial resolution, and get the spatial resolution for the near-field probe. In the invention, the spatial resolution for near-field probe is represented as spatial resolution @ coverage of amplitude accuracy (confidence coefficient is xx%). Take PXI N9030A signal analyzer of Keysight as an example. The amplitude accuracy of the signal analyzer is $\pm$0.19dB within the range of 10Hz ~ 3.6GHz. The confidence coefficient of the measurement result is 95%. Therefore, if the signal analyzer is used in the near-field EMI testing system, according to the representation for the spatial resolution of near-field probe given above, as for a certain near-field probe, the spatial resolution can be expressed as 2mm@0.38dB (confidence coefficient is 95%). The above-mentioned contents is carried in the priority documents CN201710081830.5 of this invention.

When using the formula analysis on the field distribution to calibrate the spatial resolution, the following technical scheme is adopted:

Step 1: Input one signal at the origin end of transmission line, and set up short circuit or open circuit or load pure reactance at the loading end so as to generate the total reflection and make the signal inside the transmission line become pure standing wave.

The magnetic field right above the conduction band of transmission line:

$$\left|\vec{H}(z)\right| = \left|\vec{H_0^+}\right| e^{-\alpha z}\left|1 - |\Gamma_L|e^{2\alpha z}e^{j(\varphi_L + 2\beta z)}\right| =$$

$$\left|\vec{H_0^+}\right| e^{-\alpha z}\sqrt{1 + |\Gamma_L|^2 e^{4\alpha z} - 2|\Gamma_L|e^{2\alpha z}\cos(\varphi_L + 2\beta z)}, \text{ and } |\Gamma_L| = 1 \circ$$

The period of EMF along X direction is half the wave length. The maximum value occurs when $\varphi_L + 2\beta z = (2n + 1)\pi$. n is non-negative integer. The maximum value is $\left|\overrightarrow{H_0^+}\right| e^{-\alpha z}(1 + e^{2\alpha z})$. The minimum value occurs when $\varphi_L + 2\beta z = 2n\pi$. n is non-negative integer. The minimum value is $\left|\overrightarrow{H_0^+}\right| e^{-\alpha z}(1 - e^{2\alpha z})$.

Step 2: Set up field probe at a certain height right above the conduction band of transmission and the probe outputs signal to measurement & analysis equipment as indicated in Fig.2. Adjust the orientation of signal source, measurement, analysis and reception equipment as well as the normal ring surface of probe until the signal can be clearly observed, and make sure that the measurement and analysis equipment has sufficient amplitude dynamic range. Step 3: Keep the height unchanged and make probe move in the direction of signal transmission of the line. Please record the change of signal measured. The change of signal measured is equal to the displacement distance $\Delta l$ of the system amplitude resolution $R_A$ (dB) . This distance shall be the spatial resolution specified in the derivative definition. At this time, the magnetic field modulus value measured by the probe changes by $\Delta|\overrightarrow{H}|$ (dB). Therefore, the spatial resolution can be expressed as $\Delta l@ (\Delta|\overrightarrow{H}| = R_A)$.

Step 4: furthermore, the derivative definition of the spatial resolution in the calibration field is

$$\Delta l@ \left(\Delta|\overrightarrow{H}| = R_A, \left|\overrightarrow{H_0^+}\right| e^{-\alpha z}\left|1 - e^{2\alpha z}e^{j(\varphi_L + 2\beta z)}\right|\right).$$

**Content six: calibration method of low-frequency standing wave for field probe**

Step 1: Input one signal at the origin end of transmission line, and set up short circuit or open circuit or load pure reactance at the loading end so as to generate total reflection and make the signal inside the transmission line become pure standing wave.

The electric field right above the conduction band of transmission line:

$$\left|\overrightarrow{E}(z)\right| = \left|\overrightarrow{E_0^+}\right| e^{-\alpha z}\left|1 + |\Gamma_L|e^{2\alpha z}e^{j(\varphi_L + 2\beta z)}\right| =$$

$$\left|\overrightarrow{E_0^+}\right| e^{-\alpha z}\sqrt{1 + |\Gamma_L|^2 e^{4\alpha z} + 2|\Gamma_L|e^{2\alpha z}\cos(\varphi_L + 2\beta z)}, \text{ and } |\Gamma_L| = 1_{\circ}$$

The period of EMF along X direction is half the wave length. The maximum value occurs when $\varphi_L + 2\beta z = 2n\pi$. n is non-negative integer. The maximum value is $\left|\overrightarrow{E_0^+}\right| e^{-\alpha z}(1 + e^{2\alpha z})$. The minimum value occurs when $\varphi_L + 2\beta z = (2n + 1)\pi$. n is non-negative integer. The minimum value is $\left|\overrightarrow{E_0^+}\right| e^{-\alpha z}(1 - e^{2\alpha z})$.

Step 2: Set up field probe at a certain height right above the conduction band of transmission and the probe outputs signal to measurement & analysis equipment as indicated in Fig.3. Adjust the orientation of signal source, measurement, analysis and reception equipment as well as the polarization of probe until the signal can be clearly observed, and make sure that the measurement and analysis equipment has sufficient amplitude dynamic range.

Step 3: Keep the height unchanged and make probe move in the direction of signal transmission of the line. Please record the change of signal measured. The change of signal measured is equal to the displacement distance $\Delta l$ of the system amplitude resolution $R_A$ (dB) . This distance shall be the spatial resolution specified in the derivative definition. At this time, the field modulus value measured by the probe changes by $\Delta|\overrightarrow{E}|$ (dB) . Therefore, the spatial resolution can be expressed as $\Delta l@ (\Delta|\overrightarrow{E}| = R_A)$ .

Step 4: furthermore, the derivative definition of the spatial resolution in the calibration field is

$$\Delta l@ \left(\Delta|\overrightarrow{E}| = R_A, \left|\overrightarrow{E_0^+}\right| e^{-\alpha z}\left|1 + e^{2\alpha z}e^{j(\varphi_L + 2\beta z)}\right|\right).$$

The advantages of this invention in:

1. Put forward the derivative definition on the probe spatial resolution and define the influence of amplitude resolution of the measurement system and field distribution of calibration platform on the testing results in the derivative definition, and normalize these influence so as to make sure the testing results of the probe in different measurement system and under different calibration platform have comparability.

2. Invent a controllable probe calibration platform with axis distribution of EMF. Through adjusting the the load of the transmission line, to control the axial gradient distribution of the modulus value of EMF above the control platform. The axial gradient distribution of the EMF's modulus value can be adjusted according to the probe sizes and testing frequency needs so as to facilitate testing.

3.Put forward a calibration method suitable for high-frequency travelling wave. Under high frequency, as for planar transmission line, suitable attenuation factor $\alpha$ can be obtained by choosing suitable materials and the absolute value of axial gradient for the modulus value of EMF can be increased (or decreased) so as to acquire suitable displacement distance and platform length for probe. The field modulus value can be expressed with logarithm. Therefore, the axial gradient of modulus value for travelling wave field is a constant gradf[[$|\vec{E}|$ (z)|] = gradf[[$|\vec{H}$ (z)|] = -8.686$\alpha$ (dB/m). However, the calibration method for travelling wave may not be suitable to low frequency. It's difficult to select suitable materials so as to obtain sufficiently big attenuation factor $\alpha$ under low frequency. Therefore, it will cost a high pay to increase the absolute value of axial gradient for the modulus value of high and low-frequency EMF.

4. Put forward a calibration method suitable for low-frequency standing wave. Under low frequency, as for planar transmission line, the maximum value can change to the minimum value when the standing wave is within 1/4 of the wave length. This effectively increase the axial absolute value for the modulus value of EMF.

The gradient of the modulus value for electric field of standing wave

$$\text{gradf}\big[\big|\vec{\mathrm{E}}\ (z)\big|\big] = 17.372\mathrm{e}^{2\alpha z}\frac{\alpha \mathrm{e}^{2\alpha z}+\alpha\cos(\varphi_L+2\beta z)\text{-}\beta\sin(\varphi_L+2\beta z)}{1+\mathrm{e}^{4\alpha z}+2\mathrm{e}^{2\alpha z}\cos(\varphi_L+2\beta z)}\text{-}8.686\alpha\ (\text{dB/m})$$

The gradient of the modulus value for magnetic field of standing wave

$$\text{gradf}\big[\big|\vec{\mathrm{H}}\ (z)\big|\big] = 17.372\mathrm{e}^{2\alpha z}\frac{\alpha \mathrm{e}^{2\alpha z}\text{-}\alpha\cos(\varphi_L+2\beta z)+\beta\sin(\varphi_L+2\beta z)}{1+\mathrm{e}^{4\alpha z}\text{-}2\mathrm{e}^{2\alpha z}\cos(\varphi_L+2\beta z)}\text{-}8.686\alpha\ (\text{dB/m})$$

Select suitable materials so as to make attenuation factor $\alpha$ very small or approach zero. In this case, the transmission line can be believed to be non-loss material. It can be simplified as

$$\text{gradf}\big[\big|\vec{\mathrm{E}}\ (z)\big|\big] = 17.372\frac{\text{-}\beta\sin(\varphi_L+2\beta z)}{2+2\cos(\varphi_L+2\beta z)} = 8.686\frac{\text{-}2\beta\sin(0.5\varphi_L+\beta z)\cos(0.5\varphi_L+\beta z)}{2\cos^2(0.5\varphi_L+\beta z)} =$$

$$\text{-}8.686\beta\ \tan(0.5\varphi_L$$

$$\text{gradf}\big[\big|\vec{\mathrm{H}}\ (z)\big|\big] = 17.372\frac{\beta\sin(\varphi_L+2\beta z)}{2\text{-}2\cos(\varphi_L+2\beta z)} =$$

$+$ $\beta z)$ (dB/m),

$$8.686\frac{2\beta\sin(0.5\varphi_L+\beta z)\cos(0.5\varphi_L+\beta z)}{2\sin^2(0.5\varphi_L+\beta z)} = 8.686\beta\cot(0.5\varphi_L + \beta z)\ (\text{dB/m}).$$

We can see that by choosing z, we can obtain very big or very small absolute values of gradient for the field modulus value so as to facilitate testing. When the relatively small absolute value of gradient for the modulus value of magnetic field or when the relatively big absolute value of gradient for the modulus value of electric field is required, short circuit can be chosen at the terminal end so as to make testing in case z = 0. When the relatively big absolute value of gradient for the modulus value of magnetic field or when the relatively small absolute value of gradient for the modulus value of electric field is required, open circuit can be chosen at the terminal end so as to make testing in case z = 0.

**Description to the drawings**

Fig. la is the schematic diagram of the principle for calibration platform of probe spatial resolution.

Fig. 1b is the schematic diagram of the process for calibration method.

Fig. 2 is the schematic diagram of spatial resolution calibration method for the probe of magnetic field.

Fig. 3 is the schematic diagram of spatial resolution calibration method for the probe of magnetic field.

Fig. 4 is the schematic diagram of EMF distribution for micro-strip line.

Fig. 5 is the schematic diagram of EMF distribution for coplanar waveguide.

Fig. 6 is the schematic diagram of linear fitting calibration method for near-field probe.

Fig. 7 is the schematic diagram when the near-field probe in the linear fitting calibration method moves on the measurement baseline with constant speed.

Fig. 8 is the schematic diagram when the measurement result of spatial resolution calibration is corrected in the linear fitting calibration method.

**Detailed execution**

The invention puts forward a spatial resolution calibration method based on the controllable probe with axial-distribution EMF of planar transmission lines. The further detailed description is made on the invention in combination with the drawings and examples. As indicated in Fig. 1b, the invention is executed as follows:

1. To give derivative definition on the probe spatial resolution through normalization

1.1 Use the amplitude resolution of measurement & analysis equipment as recognizable base of field strength change in order to measure the spatial resolution. The spatial resolution can be derivatively defined as the spatial range of probe change @ (field strength change= amplitude resolution), i.e. $\Delta l$@ ($\Delta|\vec{A}| = R_A$)". The amplitude accuracy index is usually given in the measurement system. Fox example, when the amplitude accuracy (N9030A signal analyzer of Keysight) $A_A = \pm 0.19$dB within 10Hz~3.6GHz, the confidence coefficient is 95%. that's to say, if the amplitude difference between two measurements for a common signal is $\geq 0.38$dB, the probability of amplitude change is $\geq 95\%$. therefore, the spatial resolution for N9030A signal analyzer can be described with $\Delta l$@ ($\Delta|\vec{A}| = 0.38$dB, P = 0.95) . P stands for the probability of confidence coefficient, i.e. the definition of spatial resolution mentioned in the priority documents CN 201710081830 .5.

1.2 Furthermore, according to the above-mentioned contents, the field distribution function is added to give further definition on the probe spatial resolution. Describe the distribution of spatial field $\vec{A}$ with logarithm. Here, $\vec{A}$ stands for electric field or magnetic field. The modulus value of $\vec{A}$ is distributed as $|\vec{A}|(x,y,z)$(dB) = $20log[|\vec{A}|(x,y,z)]$. We watch the gradient of $\vec{A}$ in a certain direction. Generally, it's supposed to be in Z direction. The distribution of modulus value of $\vec{A}$ can be simplified as $|\vec{A}|(z)$(dB). Therefore, $gradf[|\vec{A}(z)dB|] = \dfrac{\partial[20lg|\vec{A}|(z)]}{\partial z} = \dfrac{8.686}{|\vec{A}|(z)}\dfrac{\partial|\vec{A}|(z)}{\partial z}$. When $\Delta|\vec{A}| = R_A$, the probe will change following $\Delta l$, i.e.

$$\int_{z+\Delta l}^{z} gradf[|\vec{A}(z)dB|]\,dz = \int_{z+\Delta l}^{z} \frac{8.686}{|\vec{A}|(z)}\frac{\partial|\vec{A}|(z)}{\partial z}\,dz = \int_{z+\Delta l}^{z}\frac{8.686}{|\vec{A}|(z)}\,d|\vec{A}|(z) =$$

$$8.686\ln|\vec{A}|(z)\Big|_{z+\Delta l}^{z} = 8.686\ln|\vec{A}|(z) - 8.686\ln|\vec{A}|(z+\Delta l) = R_A. \quad \text{Therefore,} \quad \frac{|\vec{A}|(z+\Delta l)}{|\vec{A}|(z)} =$$

$e^{-0.1151R_A}$. We can see that the spatial resolution of probe is related to the field distribution and the amplitude resolution of the measurement system. It has nothing to do with the probe itself.

1.3 As for travelling wave in Z direction, the field distribution is $|\vec{A}|e^{-\alpha z}$.

$$e^{-0.1151R_A} = \frac{|\vec{A}|(z+\Delta l)}{|\vec{A}|(z)} =$$

$$\frac{|\vec{A}|e^{-\alpha(z+\Delta l)}}{|\vec{A}|e^{-\alpha z}} = e^{-\alpha\Delta l}. \qquad \alpha\Delta l = 0.1151R_A. \qquad \Delta l = \frac{0.1151R_A}{\alpha}.$$

$R_A$ is equal to $A_A$. The theoretical value of the calibration is obtained.

1.4 As for the pure standing wave in Z direction, when the attenuation factor $\alpha$ is very small and approach 0, the field distribution is $\left|\overrightarrow{A_0^+}\right|\left|1 \pm e^{j(\varphi_L+2\beta z)}\right|$. When it's positive, the field distribution is $\left|\overrightarrow{A_0^+}\right|\sqrt{2+2\cos(\varphi_L+2\beta z)}=2\left|\overrightarrow{A_0^+}\right|\left|\cos(0.5\varphi_L+\beta z)\right|$. When it's negative, the field distribution is $\left|\overrightarrow{A_0^+}\right|\sqrt{2\text{-}2\cos(\varphi_L+2\beta z)}=2\left|\overrightarrow{A_0^+}\right|\left|\sin(0.5\varphi_L+\beta z)\right|$. The initial position z can be controlled so that the positive and negative signs of cos(0.5$\varphi_L$+ $\beta$z) and cos(0.5$\varphi_L$ + $\beta$z + $\beta\Delta$l), sin(0.5$\varphi_L$ + (3z) and sin(0.5$\varphi_L$ + $\beta$z + $\beta\Delta$l) are same, respectively. Therefore, $\Delta l = \frac{1}{\beta}\cos^{-1}[e^{-0.1151R_A}\cos(0.5\varphi_L+\beta z)]\text{-}\frac{0.5\varphi_L}{\beta}\text{-z}$ or $\Delta l = \frac{1}{\beta}\sin^{-1}[e^{-0.1151R_A}\sin(0.5\varphi_L+\beta z)]\text{-}\frac{0.5\varphi_L}{\beta}\text{-z}$. $R_A$ is equal to $A_A$. The theoretical value of the calibration is obtained.

2.Set up the controllable probe calibration platform with axial distribution of EMF above the planar transmission line

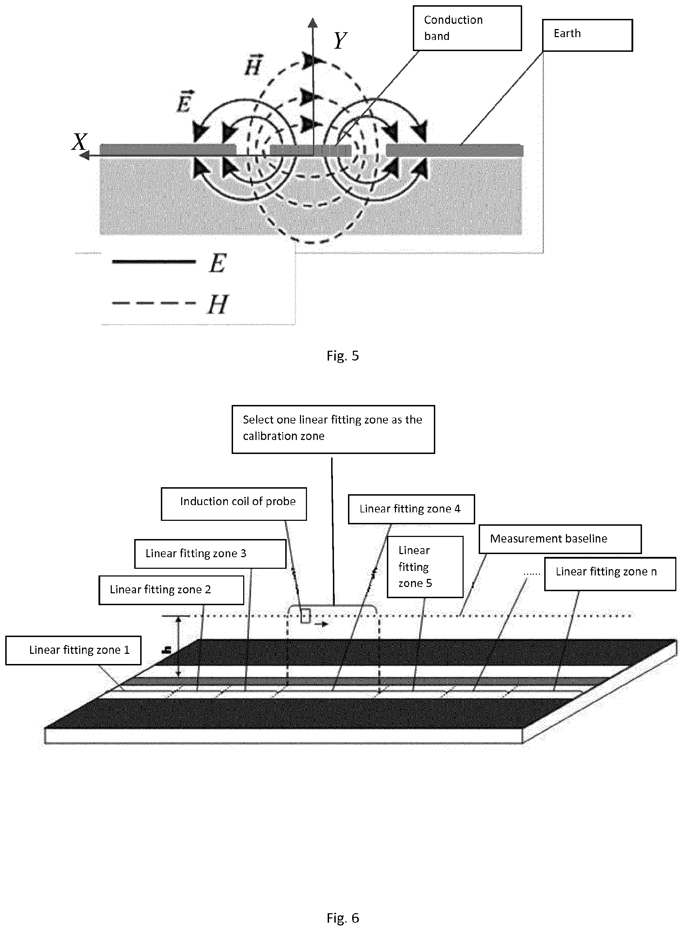

2.1 Make non-closed and even planar transmission line with length L and characteristic impedance $Z_0$. For example, use micro-strip line to increase attenuation factors in case of high frequency. And use coplanar waveguide to decrease attenuation factors in case of low frequency. Define the forward direction of signal transmission along transmission line as **Z** and the vertical direction as **X** within the plane of transmission line. Define the direction vertical to the plane of transmission line as **Y** and the origin of coordinates at the terminal of conduction band as indicated in Fig. 1a. Electromagnetic field exists in the air exposed above the micro-strip line and coplanar waveguide, as indicated in Fig.4 and Fig.5.

2.2 Make a ruler with degrees along Z direction. The degree is parallel to the conduction band.

2.3 Measure the attenuation factor $\alpha$ along the Z direction of transmission line. Unit: 1/m. Therefore, the modulus values of forward electric field and magnetic field are $|\overrightarrow{E^+}|(z)=\left|\overrightarrow{E_0^+}\right|e^{-\alpha z}$ and $\left|\overrightarrow{H^+}\right|(z)=\left|\overrightarrow{H_0^+}\right|e^{-\alpha z}$, respectively. The modulus values of reverse electric field and magnetic field are $\left|\overrightarrow{E^-}\right|(z)=\left|\overrightarrow{E_0^-}\right|e^{\alpha z}$ and $\left|\overrightarrow{H^-}\right|(z)=\left|\overrightarrow{H_0^-}\right|e^{\alpha z}$, respectively.

2.4 Input one signal at the origin end of transmission and load $Z_L$ at the terminal end. The reflection coefficient of the terminal is $\Gamma(0) = \Gamma_L = |\Gamma_L|e^{j\varphi L}$. At a same height, the axial modulus values of electric field and magnetic field are $\left|\overrightarrow{E}(z)\right| = \left|\overrightarrow{E_0^+}\right|e^{-\alpha z}\left|1+\right|\Gamma_L|e^{2\alpha z}e^{j(\varphi_L+2\beta z)}|$ and $\left|\overrightarrow{H}(z)\right| = \left|\overrightarrow{H_0^+}\right|e^{-\alpha z}\left|1\text{-}|\Gamma_L|e^{2\alpha z}e^{j(\varphi_L+2\beta z)}\right|$, respectively. To change the load $Z_L$ at the terminal can control the axial distribution of EMF above the planar transmission line.

2.5 Add fixable probe and move electromechanical structure with probe moving along X, Y and Z axis. Together with planar transmission line and scale, they form calibration platform for spatial resolution of probe.

On the basis of the spatial resolution calibration platform of probe, the following schemes are taken to calibrate the probe spatial resolution.

**Scheme 1: calibration of high-frequency travelling wave for field probe**

1. Input one signal at the origin end of transmission line and connect matching load at the loading end. In this way, the travelling wave will occur inside the micro-strip line and has no reverse signal. The field right above the conduction band of transmission line: $|\overrightarrow{H}|(z)= \left|\overrightarrow{H^+}\right|(z) = \left|\overrightarrow{H_0^+}\right|e^{-\alpha z}$.

2. Set up field probe at a certain height right above the conduction band of transmission line. The probe outputs signal to measure and analyze equipment as indicated in Fig.2. Adjust the orientation of signal source, measurement, analysis and reception equipment until the signal can be clearly observed, and make sure that the measurement, analysis and reception equipment has sufficient amplitude dynamic range. In case of normal ring surface of probe along X axis or Y axis, it's suitable to tangential resolution. And in case of normal ring surface of probe along Z axis, it's suitable to normal resolution.

Step 3: Keep the height unchanged and make probe move in -Z direction. Please record the change of signal measured. The change of signal measured is equal to the displacement distance $\Delta l$ of the system amplitude resolution $R_A$ (dB) .

Step 4: Check whether $\Delta l$ is within the error range of theoretical calibration value.

**Scheme 2: calibration of high-frequency spatial resolution for field probe with travelling wave**

1. Input one signal at the origin end of transmission line and connect matching load at the loading end. In this way, the travelling wave will occur inside the micro-strip line and has no reverse signal. The electric field right above the conduction band of transmission line: $|\vec{E}|(z) = \left|\overrightarrow{E^+}\right|(z) = \left|\overrightarrow{E_0^+}\right| e^{-\alpha z}$.

2. Set up field probe at a certain height right above the conduction band of transmission line. The probe outputs signal to measure and analyze equipment as indicated in Fig.3. Adjust the orientation of signal source, measurement, analysis and reception equipment until the signal can be clearly observed, and make sure that the measurement and analysis equipment has sufficient amplitude dynamic range. In case of polarization of probe along X axis or Y axis, it's suitable to radial resolution. And in case of polarization of probe along Z axis, it's suitable to axial resolution.

3. Keep the height unchanged and make probe move in -**Z** direction. Please record the change of signal measured. The change of signal measured is equal to the displacement distance $\Delta l$ of the system amplitude resolution $R_A$ (dB).

4: Check whether $\Delta l$ is within the error range of theoretical calibration value.

**Scheme 3: calibration of low-frequency spatial resolution for field probe with standing wave**

Just as those mentioned above, when standing wave is adopted to calibrate the low-frequency spatial resolution for the magnetic field probe, two technical schemes, i.e. linear fitting and analysis, can be used to calibrate the spatial resolution of probe.

The following technical schemes are adopted for calibration in case of linear fitting:

When the transmission line is under pure standing wave, the electric voltage /current on the transmission line has the spatial distribution feature of sine function. Please refer to the Executions in the priority documents for the deduction process of the theory. Here, no further description is needed.

Step two: regional distribution for linear fitting on the calibration scale:

In order to facilitate the subsequent analysis and treatment, the regional linear fitting is made on the following sine functions under the pre-condition of losing no generality:

$$y = \sin(x), x \in \left(\frac{\pi}{2}, \pi\right)$$

The linear fitting functions are as the following Table 1.

Table 1 Linear fitting zone of sine functions and fitting functions

| Fitting zone | Fitting functions |
| --- | --- |
| (1.5708,1.6608) | $y = 1$ |
| (1.6608,1.7608) | $y = -0.14 \cdot (x\text{-}1.7608) + 0.9828$ |
| (1.7608,1.8608) | $y = -0.24 \cdot (x\text{-}1.8608) + 0.9589$ |
| (1.8608,1.9608) | $y = -0.33 \cdot (x\text{-}1.9608) + 0.9257$ |

(continued)

| Fitting zone | Fitting functions |
| --- | --- |
| (1.9608,2.0608) | $y = -0.43 \cdot (x-2.0608)+0.8826$ |
| (2.0608,2.1808) | $y = -0.52 \cdot (x-2.1808)+0.8203$ |
| (2.1808,2.3208) | $y = -0.62 \cdot (x-2.3208)+0.7334$ |
| (2.3208,2.4708) | $y = -0.74 \cdot (x-2.4708)+0.6223$ |
| (2.4708,2.6508) | $y=-0.82 \cdot (x-2.6508)+0.4745$ |
| (2.6508,2.9708) | $y=-0.95 \cdot (x-2.9708)+0.171$ |
| (2.9708,3.1408) | $y=-1 \cdot (x-2.9708)+0.17$ |

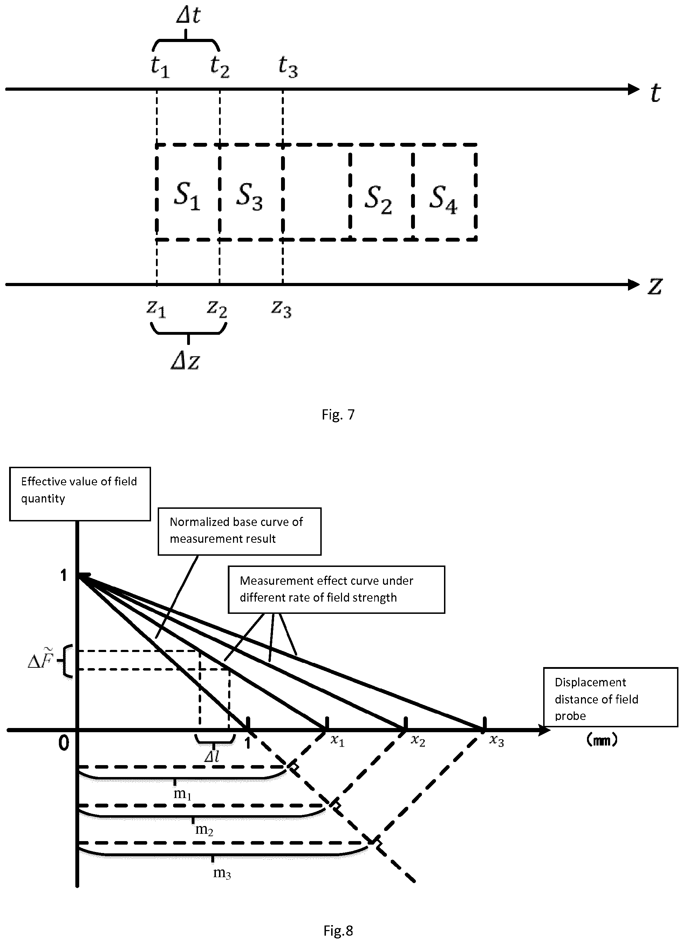

As indicated in Table 1, the fitting accuracy error for different zone is no higher than 1%. As for the field quantity with spatial distribution feature of sine function, in combination with the three-dimensional full-wave EMF simulation as well as the existing experience and formula, through anti-normalization (including parallel shit, proportion shit etc), as for the current excitation frequency of signal source, when the calibration scale runs under pure standing wave, designate the actual range corresponding to all fitting zones indicated in Table 1. As shown in Fig.8, through normalization, linear fitting zone 1, linear fitting zone 2........linear fitting zone n are designated so as to make preparation for the subsequent calibration of the probe spatial resolution.

Step three:

(1)Choose calibration zone for spatial resolution from linear fitting zones:

Through anti-normalization specified in Step 2, choose a regional length larger than the preestimated value of spatial resolution for probe to be calibrated from the practical linear fitting zone designated on the calibration scale and a sub-zone, which has no zero rate of change for the modulus value or effective value of field quantity on the measurement baseline, as the calibration zone of spatial resolution for near-field probe.

(2) Measure the spatial resolution of near-field probe:

Move the near-field probe with constant speed on the measurement baseline within the calibration zone. The measurement baseline is located on the magnetic or electric wall plane of TEM wave field, which is formed by the calibration scale. The extension direction of measurement baseline is consistent with the longitudinal extension direction of the calibration scale so as to enhance the coupling of fields and increase measurement accuracy. When moving the probe, mark the reading changes of receptor or spectrometer in the corresponding measurement system. The probe displacement distance corresponding to the minimum reading change shall be the spatial resolution of the near-field probe.

The detailed descriptions are follows:

As indicated in Fig.8, suppose that the terminal of coplanar waveguide is open-circuited. Apply one single-tone excitation $f_0$ at the input end of coplanar waveguide. The selection of this frequency must use the actual working frequency band of the corresponding near-field probe as the reference proof. Under this frequency, coplanar waveguide is under TEM transmission mode (dominant mode). (Apparent) higher mode doesn't occur. Mark a straight line parallel to the neutral line of the signal line, which is h higher above the neutral line of signal line of coplanar waveguide. This straight line is located on the surface of magnetic wall and it's defined as measurement baseline. Meanwhile, make the induction coil of near-field probe be positioned on the magnetic wall, and move the probe on the measurement baseline with constant speed within the corresponding calibration zone.

Under the precondition of losing no generality, make the following deduction on the measurement of the spatial resolution of the probe in combination with Fig.7. Suppose the induction coil of the magnetic field probe is rectangle. The probe's edge length along Z axis is L. In addition, when measuring the field quantity with receptor/ spectrometer, it refers to the modulus value/ effective value of field quantity. In case of probe calibration, as the object measured is variable field under sine function, in combination with the measurement characteristics of receptor/ spectrometer as well as within the calibration zone, through linear fitting, the modulus value or effective value of field quantity changes with the change of spatial displacement according to the spatial distribution law y=kz+b. From the Faraday's law of induction, we can get:

$$\left|\varepsilon_{ind1}\right|=\left|\frac{\Delta\Phi_1}{\Delta t}\right|=\left|\frac{\int_{S_1}\tilde{B}_1\cdot d\vec{a}-\int_{S_2}\tilde{B}_2\cdot d\vec{a}}{t_2-t_1}\right|=\left|1-\left|k\right|\cdot L\right|\cdot\left|\frac{\int_{S_1}\tilde{B}_1\cdot d\vec{a}}{\Delta t}\right|$$

$$\left|\varepsilon_{ind2}\right|=\left|\frac{\Delta\Phi_2}{\Delta t}\right|=\left|\frac{\int_{S_3}\tilde{B}_3\cdot d\vec{a}-\int_{S_4}\tilde{B}_4\cdot d\vec{a}}{t_3-t_2}\right|=\left|1-\left|k\right|\cdot L\right|\cdot\left|\frac{\int_{S_3}\tilde{B}_3\cdot d\vec{a}}{\Delta t}\right|$$

K stands for the rate of spatial change for field quantity through linear fitting.

(3) Make necessary correction on the probe's spatial resolution:

$\varepsilon_{ind1}$ stands for the induced electromotive force as indicated in Fig.7, generated by the induction coil when its left side moves from $z_1$ to $z_2$. $\varepsilon_{ind2}$ stands for the induced electromotive force as indicated in Fig.7, generated by the induction coil when its left side moves from $z_2$ to $z_3$. $\tilde{B}_{S_1}$~$\tilde{B}_{S_4}$ stand for the effective values of flux density vector for Zone 1~Zone 4 as shown in Fig.7, respectively. $S_1$~$S_4$ stand for the area for for Zone 1~Zone 4 as shown in Fig.7, respectively. $t_1$~$t_3$ stand for three continuous moments when the coil is being moved.

Meanwhile, it should be noticed:

$$S_1=S_2=S_3=S_4$$

Therefore,

$$\left|\frac{\varepsilon_{ind1}}{\varepsilon_{ind2}}\right|=\left|\frac{\int_{S_1}\tilde{B}_1\cdot d\vec{a}}{\int_{S_3}\tilde{B}_3\cdot d\vec{a}}\right|=\frac{1}{1-\left|k\right|\cdot\Delta z}$$

Furthermore,

$$\Delta\varepsilon_{ind}=-20\lg\left(1-\left|k\right|\cdot\Delta z\right)dB$$

$\Delta z$ stands for the quantity of change for coil displacement at the two neighboring moments, as shown in Fig.7. $\Delta\varepsilon_{ind}$ stands for the quantity of change for induced electromotive force on the induction coil at the two neighboring moments. Therefore, it further shows that the spatial resolution is not an absolute quantity. Its value is related to the rate of spatial change k as well as the amplitude accuracy of receptor or spectrometer in the near-field EMI testing system.
The preliminary measurement result on the corresponding spatial resolution can be obtained through actual measurement:

$$xx\ dB/\Delta z$$

(4) Make necessary correction on the probe's spatial resolution:

In order to eliminate the calibration error of the spatial resolution of near-field probe brought about by the modulus value or effective value of field quantity under different rate of spatial change, correction coefficient m is introduced to calibrate results. Multiply the correction coefficient and the probe's spatial resolution, and get the spatial resolution of near-field probe finally calibrated.

In order to clarify the solution procedure of calibration coefficient m, Fig.8 gives curve for the rates of spatial change of three field quantities through linear fitting. The rates of spatial change are $-(1/x_1)$, $-(1/x_2)$ and $-(1/x_3)$, respectively, as shown in Fig.8. The rate of spatial change for field quantity (k) can be expressed as :

$$k = -\frac{\Delta \tilde{F}}{\Delta l}$$

$\Delta \tilde{F}$ stands for the change force of field quantity through normalization. And $\Delta l$ stands for the displacement distance of probe along measurement baseline when the field quantity changes by $\Delta \tilde{F}$ through normalization.

The calibration coefficients corresponding to the distribution of three curves for the rate of spatial change for different field quantities are m1, m2 and m3, respectively. Through linear fitting, as for the distribution curve i with a certain rate of spatial change, the calculation formula corresponding to the correction coefficient $m_i$ is as follows:

$$m_i = \frac{\dfrac{(x_i - 1)}{\sqrt{2}} + \sqrt{2}}{\sqrt{2}}$$

The probe's spatial resolution through correction:

$$m \cdot \left( xx\ dB / \Delta z \right)$$

When using field distribution for formula analysis so as to calibrate the probe's spatial resolution, the following technical scheme is adopted:

1.Input one signal at the origin end of transmission line and set up open circuit at the loading end. In this way, the total reflection will occur and make the signal inside coplanar waveguide become pure standing wave. The magnetic field right above the conduction band:

$$\left| \vec{H}(z) \right| \approx \left| \overrightarrow{H_0^+} \right| \left| 1\text{-}e^{j(\varphi_L + 2\beta z)} \right| = \left| \overrightarrow{H_0^+} \right| \sqrt{2\text{-}2\cos(\varphi_L + 2\beta z)}.$$

2.Set up magnetic field probe at a certain height right above the conduction band. The probe outputs signal to measure and analyze equipment as indicated in Fig.2. Adjust the orientation of signal source, measurement, analysis and reception equipment until the signal can be clearly observed, and make sure that the measurement and analysis equipment has sufficient amplitude dynamic range. In case of normal ring surface of probe along Y axis or Z axis, it's suitable to tangential resolution. And in case of normal ring surface of probe along X axis, it's suitable to normal resolution.

3.Keep the height unchanged starting from z = 0 in order to acquire big relative value for modulus value gradient of magnetic field, and make probe move in -**Z** direction. The change of signal measured is equal to the displacement distance $\Delta l$ of the system amplitude resolution $R_A$ (dB).

4: Check whether $\Delta l$ is within the error range of theoretical calibration value.

**Scheme 4: Calibrate the low-frequency spatial resolution of electric field probe with standing wave**

1.Input one signal at the origin end of transmission line and set up short circuit at the loading end. In this way, the total reflection will occur and make the signal inside coplanar waveguide become pure standing wave. The magnetic field right above the conduction band:

$$\left|\vec{E}(z)\right| \approx \left|\vec{E_0^+}\right|\left|1 + e^{j(\varphi_L + 2\beta z)}\right| = \left|\vec{E_0^+}\right|\sqrt{2 + 2\cos(\varphi_L + 2\beta z)}.$$

2.Set up magnetic field probe at a certain height right above the conduction band. The probe outputs signal to measure and analyze equipment as indicated in Fig.3. Adjust the orientation of signal source, measurement, analysis and reception equipment until the signal can be clearly observed, and make sure that the measurement and analysis equipment has sufficient amplitude dynamic range. In case of polarization of probe along Y axis or X axis, it's suitable to radial resolution. And in case of polarization of probe along Z axis, it's suitable to axial resolution.

3.Keep the height unchanged starting from z = 0 in order to acquire big relative value for modulus value gradient of magnetic field, and make probe move in -*Z* direction. The change of signal measured is equal to the displacement distance $\Delta l$ of the system amplitude resolution $R_A$ (dB).

4: Check whether $\Delta l$ is within the error range of theoretical calibration value.

The above-mentioned examples is only applicable to the execution process of this invention. The protection scope of the invention is not limited to the above-mentioned examples. Any technical scheme generated from the thoughts of this invention falls into the protection scope of this invention.

**Claims**

1. A spatial resolution calibration method based on the controllable probe with axial-distribution EMF of planar transmission lines **characterized in** the following steps:

   Step 1Giving the derivative definition on the spatial resolution of probe through normalization: Making amplitude resolution as the recognizable base of field strength changes so as to measure the spatial resolution; the spatial resolution is defined derivatively as the spatial range of probe changes (field strength change=amplitude resolution); further defining the spatial resolution of probe with distribution function, then the spatial resolution can be further derivatively defined as the spatial range of probe changes (field strength change=amplitude resolution, $|\vec{A}|(x,y,z)(dB)$)
   Step 2: Setting up the controllable probe calibration platform for axial-distribution EMF above the planar transmission line: Choosing the detailed form of multi-conductor planar transmission line used for setting up calibration scale and set up open circuit or short circuit for terminal of transmission line so as to make it run under pure standing wave; with the above-mentioned multi-conductor uniform transmission line, under the condition of standing wave or travelling wave, to set up the calibration scale used for calibrating the spatial resolution of near-field probe and meanwhile with resolvable features corresponding to the EMF distribution according to the correlation among TEM waves of voltage wave/current wave on the transmission line and excited near the transmission line; The calibration scale is parallel to the conduction band along Z direction and has degree scale; Measuring the attenuation factor $\alpha$ along the Z direction of transmission line with unit 1/m. Giving one signal input at the origin of transmission line and load $Z_L$ at the terminal; Then (the reflection coefficient of terminal) $\Gamma(0) = \Gamma_L = |\Gamma_L|e^{j\varphi_L}$; Adding fixable probe and move electromechanical structure with probe moving along X, Y and Z axis; Together with planar transmission line and scale, they form calibration platform for spatial resolution of probe;
   Step 3: On the basis of Step 2, calibrating the spatial resolution of probe according to the following method : Calibrating the high-frequency spatial resolution of probe in magnetic field according to travelling wave method; to calibrate the high-frequency spatial resolution of probe in electric field according to travelling wave method; to calibrate the low-frequency spatial resolution of probe in magnetic field according to standing wave method; to calibrate the low-frequency spatial resolution of probe in electric field according to standing wave method.

2. The spatial resolution calibration method according to Claim 1, **characterized in that**:

   Step 1 is executed as follows:

   Describe the distribution of spatial field $\vec{A}$ with logarithm; Here, $\vec{A}$ stands for electric field or magnetic field; The modulus value of A is distributed as $|\vec{A}|(x,y,z)(dB) = 20log[|\vec{A}|(x,y,z)]$ ; We watch the gradient of $\vec{A}$ in a certain direction; Generally, it's supposed to be in Z direction; The distribution of modulus value of $\overline{A}$ can be simplified as $|\vec{A}|(z)(dB)$ ;

Therefore, $grad f\left[\left|\vec{A}(z)dB\right|\right] = \frac{\partial\left[20lg\left|\vec{A}\right|(z)\right]}{\partial z} = \frac{8.686}{\left|\vec{A}\right|(z)}\frac{\partial\left|\vec{A}\right|(z)}{\partial z};$ When $\Delta\left|\vec{A}\right| = R_A$, the probe will change following $\Delta l$, i.e.

$$\int_{z+\Delta l}^{z} grad f\left[\left|\vec{A}(z)dB\right|\right] dz = \int_{z+\Delta l}^{z} \frac{8.686}{\left|\vec{A}\right|(z)}\frac{\partial\left|\vec{A}\right|(z)}{\partial z} dz =$$

$$\int_{z+\Delta l}^{z} \frac{8.686}{\left|\vec{A}\right|(z)} d\left|\vec{A}\right|(z) = 8.686\ln\left|\vec{A}\right|(z)\Big|_{z+\Delta l}^{z} = 8.686\ln\left|\vec{A}\right|(z) - 8.686\ln\left|\vec{A}\right|(z+\Delta l) = R_A;$$

Therefore, $\frac{\left|\vec{A}\right|(z+\Delta l)}{\left|\vec{A}\right|(z)} = e^{-0.1151R_A};$ It can be seen that the spatial resolution of probe is related to the field distribution and the amplitude resolution of the measurement system, and is not related to probe itself.

**3.** The spatial resolution calibration method according to Claim 1, **characterized in that**: the high-frequency spatial resolution of field probe calibrated according to travelling wave specified in the Step 3 is executed as follows:

Step (1): Giving one signal input at the origin end of transmission line and connect matching load at the loading end; In this way, the travelling wave will occur inside the transmission line and has no reverse signal; The field right above the conduction band of transmission line: $\left|\vec{H}\right|(z) = \left|\overrightarrow{H^+}\right|(z) = \left|\overrightarrow{H_0^+}\right|e^{-\alpha z};$

Step (2): Setting up field probe at a certain height right above the conduction band of transmission line; The probe outputs signal to measure and analyze equipment; Adjusting the orientation of signal source, measurement, analysis and reception equipment as well as the normal ring surface of probe until the signal can be clearly observed, and making sure that the measurement, analysis and reception equipment has sufficient amplitude dynamic range;

Step (3): Keeping the height unchanged and make probe move in the direction of signal transmission of the line; recording the change of signal measured; The change of signal measured is equal to the displacement distance $\Delta l$ of the system amplitude resolution $R_A$ (dB) ; This distance shall be the spatial resolution specified in the derivative definition; At this time, the field modulus value measured by the probe changes by $\Delta\left|\vec{H}\right|$ (dB); Therefore, the spatial resolution can be expressed as $\Delta l@\left(\Delta\left|\vec{H}\right| = R_A\right);$

Step (4): The derivative definition of the spatial resolution in the calibration field is

$$\Delta l@\left(\Delta\left|\vec{H}\right| = R_A, \left|\overrightarrow{H_0^+}\right|e^{-\alpha z}\right);$$

**4.** The spatial resolution calibration method according to claim 1, **characterized in that**: the high-frequency spatial resolution of field probe calibrated according to the travelling wave specified in the Step 3 is executed as follows:

Step (1): Giving one signal input at the origin end of transmission line and connect matching load at the loading end; In this way, the travelling wave will occur inside the transmission line and has no reverse signal; The field right above the conduction band of transmission line:

$$\left|\vec{E}\right|(z) = \left|\overrightarrow{E^+}\right|(z) = \left|\overrightarrow{E_0^+}\right|e^{-\alpha z};$$

Step (2): Setting up field probe at a certain height right above the conduction band of transmission line; The probe outputs signal to measure and analyze equipment as indicated in Fig.3; Adjusting the orientation of signal source, measurement, analysis and reception equipment as well as the polarization of probe until the signal can be clearly observed, and make sure that the measurement and analysis equipment has sufficient amplitude dynamic range;

Step (3): Keeping the height unchanged and make probe move in the direction of signal transmission of the line; Recording the change of signal measured; The change of signal measured is equal to the displacement distance $\Delta l$ of the system amplitude resolution $R_A$ (dB) ; This distance shall be the spatial resolution specified in the derivative definition; At this time, the field modulus value measured by the probe changes by $\Delta|\vec{E}|$ (dB) ; Therefore, the spatial resolution can be expressed as $\Delta l @$ ($\Delta|\vec{E}| = R_A$) ;

Step (4): The derivative definition of the spatial resolution in the calibration field is

$$\Delta l @ \left( \Delta|\vec{H}| = R_A, \left|\overrightarrow{E_0^+}\right| e^{-\alpha z} \right).$$

**5.** The spatial resolution calibration method according to claim 1, **characterized in that**: the low-frequency spatial resolution of field probe calibrated according to the standing wave specified in the Step 3 mentioned is executed as follows:

Step (1): Giving one input signal at the origin end of transmission line and make short circuit or open circuit at the loading end or load the pure reactance; The total reflection will occur, which will make the signal inside the transmission line become pure standing wave; The field right above the conduction band of the line:

$$\left|\vec{H}(z)\right| = \left|\overrightarrow{H_0^+}\right| e^{-\alpha z} \left|1 - |\Gamma_L|e^{2\alpha z}e^{j(\varphi_L + 2\beta z)}\right| =$$

$$\left|\overrightarrow{H_0^+}\right| e^{-\alpha z}\sqrt{1 + |\Gamma_L|^2 e^{4\alpha z} - 2|\Gamma_L|e^{2\alpha z}\cos(\varphi_L + 2\beta z)}, \text{ and } |\Gamma_L| = 1,$$

$$\left|\vec{E}\right|(z) = \left|\overrightarrow{E^+}\right|(z) = \left|\overrightarrow{E_0^+}\right| e^{-\alpha z};$$

At this time, the period that the field changes along the direction of X is half the wave length; The maximum value occurs when $\varphi_L + 2\beta z = (2n + 1)\pi$ wherein n is non-negative integer; The maximum value is $\left|\overrightarrow{H_0^+}\right| e^{-\alpha z}(1 + e^{2\alpha z})$; The minimum value occurs when $\varphi_L + 2\beta z = 2n\pi$ wherein n is non-negative integer; The minimum value is $\left|\overrightarrow{H_0^+}\right| e^{-\alpha z}(1 - e^{2\alpha z})$;

Step (2): Setting up field probe at a certain height right above the conduction band of transmission line; The probe outputs signal to measure and analyze equipment as indicated in Fig.2; Adjusting the orientation of signal source, measurement, analysis and reception equipment as well as the normal ring surface of probe until the signal can be clearly observed, and make sure that the measurement and analysis equipment has sufficient amplitude dynamic range;

Step (3): Keeping the height unchanged and make probe move in the direction of signal transmission of the line; Recording the change of signal measured; The change of signal measured is equal to the displacement distance $\Delta l$ of the system amplitude resolution $R_A$ (dB) ; This distance shall be the spatial resolution specified in the derivative definition; At this time, the field modulus value measured by the probe changes by $\Delta|\vec{H}|$ (dB) ; Therefore, the spatial resolution can be expressed as $\Delta l @$ ($\Delta|\vec{H}| = R_A$) ;

Step (4): The derivative definition of the spatial resolution in the calibration field is

$$\Delta l @ \left( \Delta|\vec{H}| = R_A, \left|\overrightarrow{H_0^+}\right| e^{-\alpha z} \left|1 - e^{2\alpha z}e^{j(\varphi_L + 2\beta z)}\right| \right).$$

**6.** The spatial resolution calibration method according to claim 1, **characterized in that**: the low-frequency spatial resolution of field probe calibrated according to the standing wave specified in the Step 3 is executed as follows:

Step (1): Giving one signal input at the origin end of transmission line and make short circuit or open circuit at the loading end or load the pure reactance; The total reflection will occur, which will make the signal inside the transmission line become pure standing wave; The field right above the conduction band of the line:

$$\left|\vec{E}\,(z)\right| = \left|\overrightarrow{E_0^+}\right| e^{-\alpha z}\left|1 + |\Gamma_L|e^{2\alpha z}e^{j(\varphi_L+2\beta z)}\right| =$$

$$\left|\overrightarrow{E_0^+}\right| e^{-\alpha z}\sqrt{1 + |\Gamma_L|^2 e^{4\alpha z} + 2|\Gamma_L|e^{2\alpha z}\cos(\varphi_L + 2\beta z)}, \text{ and } |\Gamma_L| = 1$$

At this time, the period that the electric field changes along the direction of X is half the wave length; The maximum value occurs when $\varphi_L + 2\beta z = 2n\pi$ wherein n is non-negative integer; The maximum value is

$$\left|\overrightarrow{E_0^+}\right| e^{-\alpha z}(1 + e^{2\alpha z});$$ The minimum value occurs when $\varphi_L + 2pz = (2n + 1)\pi$ wherein n is non-negative integer; the minimum value is $\left|\overrightarrow{E_0^+}\right| e^{-\alpha z}(1 - e^{2\alpha z});$

Step (2): Setting up field probe at a certain height right above the conduction band of transmission line; The probe outputs signal to measure and analyze equipment as indicated in Fig.3; Adjusting the orientation of signal source, measurement, analysis and reception equipment as well as the polarization of probe until the signal can be clearly observed, and make sure that the measurement and analysis equipment has sufficient amplitude dynamic range;

Step (3): Keeping the height unchanged and make probe move in the direction of signal transmission of the line; Recording the change of signal measured; The change of signal measured is equal to the displacement distance $\Delta l$ of the system amplitude resolution $R_A$ (dB) ; This distance shall be the spatial resolution specified in the derivative definition; At this time, the field modulus value measured by the probe changes by $\Delta|\vec{E}|$ (dB) ; Therefore, the spatial resolution can be expressed as $\Delta l@ (\Delta|\vec{E}| = R_A)$ ;

Step (4): The derivative definition of the spatial resolution in the calibration field is

$$\Delta l@ \left(\Delta|\vec{E}| = R_A, \left|\overrightarrow{E_0^+}\right| e^{-\alpha z}\left|1 + e^{2\alpha z}e^{j(\varphi_L+2\beta z)}\right|\right).$$

$Y$

$X$

$-L$

$0$

scale

$Z$

$I_L$

$Z_g$

$V(z)\ I(z)$

$+$

$V_g$

$Z_0$ $\quad \alpha\ \beta$

$V(0)=V_L$ $\quad Z_L$

$-$

Fig.1a

Give derivative definition on the probe's spatial resolution through normalization

Set up the controllable probe calibration platform with axial distribution of EMF above the planar transmission line

On the basis of the calibration platform for the probe spatial resolution, the following technical scheme is adopted to calibrate the spatial resolution: calibrate the high-frequency spatial resolution of the magnetic field probe with travelling wave; calibrate the high-frequency spatial resolution of the electric field probe with travelling wave; calibrate the low-frequency spatial resolution of the magnetic field probe with standing wave; calibrate the low-frequency spatial resolution of the electric field probe with standing wave

Fig.1b

Induction coil of the magnetic field probe

Normal ring surface of probe

Trajectory of probe movement

Forward direction of probe

Conduction band

h

$Z_g$

$V_g$

$Z_L$

1. Connect matching load at the terminal with travelling wave
2. Set up short circuit, open circuit or connect pure reactance load at the terminal with standing wave

Fig.2

Polarization direction of probe

Short dipole of electric field probe

Trajectory of probe movement

Forward direction of probe

Conduction band

h

$Z_g$

$V_g$

$Z_L$

1. Connect matching load at the terminal with travelling wave
2. Set up short circuit, open circuit or connect pure reactance load at the terminal with standing wave

Fig.3

$Y$

Conduction band

Earth

$X$

$E$

$H$

Fig.4

Conduction band

Earth

Fig. 5

Select one linear fitting zone as the calibration zone

Induction coil of probe

Linear fitting zone 4

Linear fitting zone 3

Linear fitting zone 2

Linear fitting zone 1

Linear fitting zone 5

Measurement baseline

Linear fitting zone n

Fig. 6

Fig. 7

Fig.8

Europäisches
Patentamt

European
Patent Office

Office européen
des brevets

# EUROPEAN SEARCH REPORT

Application Number

EP 18 15 6850

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2013/002275 A1 (MIN KYUNG JIN [US] ET AL) 3 January 2013 (2013-01-03) * paragraphs [0018] - [0035]; claims 1-2; figures 1-3 * ----- | 1-6 | INV. G01R35/00 G01R29/08 |
| X | US 2012/161803 A1 (YEO SOON IL [KR] ET AL) 28 June 2012 (2012-06-28) * paragraphs [0034] - [0058]; claims 1-16; figures 1-5 * ----- | 1-6 | |
| X | WO 02/12907 A2 (QUALCOMM INC [US]) 14 February 2002 (2002-02-14) * paragraphs [0147], [0182] - [0199], [0247] - [0251], [0258] - [0299]; claim 40; figures 24,25 * ----- | 1-6 | |
| X | JP 2000 214198 A (HITACHI LTD) 4 August 2000 (2000-08-04) * abstract; figures 1-16 * ----- | 1-6 | |
| X | US 4 673 870 A (STRICKLAND BRIAN R [US] ET AL) 16 June 1987 (1987-06-16) * column 1, line 14 - column 5, last line; claims 1-7; figure 1 * ----- | 1-6 | TECHNICAL FIELDS SEARCHED (IPC) G01R |

The present search report has been drawn up for all claims

| Place of search | Date of completion of the search | Examiner |
|---|---|---|
| Munich | 22 August 2018 | Bilzer, Claus |

EPO FORM 1503 03.82 (P04C01)

## ANNEX TO THE EUROPEAN SEARCH REPORT
## ON EUROPEAN PATENT APPLICATION NO.

EP 18 15 6850

This annex lists the patent family members relating to the patent documents cited in the above-mentioned European search report.
The members are as contained in the European Patent Office EDP file on
The European Patent Office is in no way liable for these particulars which are merely given for the purpose of information.

22-08-2018

| Patent document cited in search report | | | Publication date | Patent family member(s) | | | Publication date |
|---|---|---|---|---|---|---|---|
| US 2013002275 | A1 | | 03-01-2013 | NONE | | | |
| US 2012161803 | A1 | | 28-06-2012 | KR | 20120070789 | A | 02-07-2012 |
| | | | | US | 2012161803 | A1 | 28-06-2012 |
| WO 0212907 | A2 | | 14-02-2002 | AU | 8110101 | A | 18-02-2002 |
| | | | | CN | 1454318 | A | 05-11-2003 |
| | | | | JP | 2004522934 | A | 29-07-2004 |
| | | | | KR | 20030020964 | A | 10-03-2003 |
| | | | | WO | 0212907 | A2 | 14-02-2002 |
| JP 2000214198 | A | | 04-08-2000 | JP | 3689578 | B2 | 31-08-2005 |
| | | | | JP | 2000214198 | A | 04-08-2000 |
| US 4673870 | A | | 16-06-1987 | NONE | | | |

EPO FORM P0459

For more details about this annex : see Official Journal of the European Patent Office, No. 12/82

**EP 3 382 418 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- CN 201710081830